Europäisches Patentamt

European Patent Office

Office européen des brevets

(11) Publication number: **0 210 423 B1**

## EUROPEAN PATENT SPECIFICATION

(45) Date of publication of patent specification: **15.04.92**  (51) Int. Cl.⁵: **G09G  1/28**

(21) Application number: **86108460.6**

(22) Date of filing: **20.06.86**

(54) **Color image display system.**

(30) Priority: **04.07.85 JP 145879/85**

(43) Date of publication of application:
**04.02.87 Bulletin  87/06**

(45) Publication of the grant of the patent:
**15.04.92 Bulletin  92/16**

(84) Designated Contracting States:
**DE FR GB IT**

(56) References cited:

IBM TECHNICAL DISCLOSURE BULLETIN, vol. 26, no. 7A, December 1983, pages 3409-3418, New York, US; I.D. JUDD et al.: "Multiple pseudo color lookup tables in raster graphic and image displays"

COMPUTER VISION, GRAPHICS, AND IMAGE PROCESSING, vol. 21, 1983, pages 305-325, Academic Press, Inc., New York, US; J. TAJIMA: "Uniform color scale applications to computer graphics"

COMPUTER GRAPHICS, vol. 16, no. 3, July 1982, pages 297-307, ACM; P. HECKBERT: "Color image quantization for frame buffer display"

(73) Proprietor: **International Business Machines Corporation**
**Old Orchard Road**
**Armonk, N.Y. 10504(US)**

(72) Inventor: **Shinichi, Iwai 108-goh**
**Mochidaheights**
**4-1-30 Saginuma Miyamae-ku**
**Kawasaki-shi Kanagawa-ken(JP)**
Inventor: **Sakae, Uno**
**3-12-4 Nakayama Hachiohji-shi**
**Tokyo-to(JP)**

(74) Representative: **Herzog, Friedrich Joachim, Dipl.-Ing.**
**IBM Deutschland GmbH Schönaicher Strasse 220**
**W-7030 Böblingen(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a color image display system, and more particularly to a color image display system for displaying a plurality of images using a single color lookup table.

In recent years, graphic display devices with the color lookup table architecture have been increased. The number of colors which can be displayed simultaneously may range from 8 to $2^{24}$. Although it is more advantageous in the fields of animation and image processing to increase the number of colors, the capacity of the color lookup table must be increased, which leads to the rise of cost. However, since image quality lowers if the number of colors is decreased, there is a tradeoff between the cost and image quality. Therefore, the problem is how to display color images beautifully using the color lookup table of a limited capacity, in other words, what colors should be stored in the color lookup table.

A number of studies on the method of selecting colors stored in the color lookup table have been carried out, and these are roughly divided into uniform sampling and tapered or adaptive sampling. The uniform sampling is a method for sampling with equal intervals a color space such as RGB space, XYZ space, HLS space or L\*u\*v\* space. J. Tajima disclosed a uniform sampling in the L\*u\*v\* space in "Uniform Color Scale Applications to Computer Graphics", COMPUTER VISION, GRAPHICS, AND IMAGE PROCESSING, Vol. 21, No. 3, pp. 305-325, March 1983.

The L\*u\*v\* space is a color space which is created so that color differences felt by human correspond to distances in the space, and is also called the uniform color space.

In the adaptive sampling, the content of the table is changed depending on images to be displayed. The process for color image quantization by the adaptive sampling is described below. It is assumed that a color space is the RGB (Red, Green, Blue) space.

(1) Creat a histogram by sampling an input image having n bits for each of R, G and B in the space having m bits for each of R, G and B.
(2) Select colors (representative colors) to be stored in the table.
(3) Map each color in the RGB space into the table.
(4) Assign to each pixel an appropriate color in the table.

The steps which greatly affect the quality of displayed images are (2) and (4). In step (3), calculation speed is important. In step (4), if the mapping calculated in step (3) is used as it is, clear stripes are often seen in the region where colors vary smoothly, due to the quantization error. In order to decrease the quantization error, various methods such as the random noise method and error diffusion method have been developed. For step (2), some algorithms such as the popularity algorithm in which representative colors are selected from the histogram in order of frequency, and population equalization algorithm in which the RGB space is divided into a plurality of subspaces corresponding to available representative colors, respectively, each subspace containing the same number of pixels. The former and latter algorithms are disclosed in P. Heckbert, "COLOR IMAGE QUANTIZATION FOR FRAME BUFFER DISPLAY", ACM SIGGRAPH '82, pp. 297-307, July 1972, and Japanese Patent Application No. 59-84259, (EP-A-0 159 691) respectively.

The problems to be solved by the invention are as follows. Although the color image quantization methods heretofore proposed have been satisfactory to some extent when only one image is displayed, there are some problems if a plurality of images are to be displayed simultaneously on a screen, because different images usually use different colors. For example, if colors to be stored in the color lookup table are selected by the uniform sampling, a difference between a color of the original image and a color actually displayed is relatively small, but clear stripes appear in a region with a uniform chromaticity and smoothly varying brightness. In case of the adaptive sampling, since a plurality of images are processed collectively, the whole table must be rewritten each time an image is changed. Furthermore, in the adaptive sampling. Since frequently used colors are selected, a color of lower frequency may differ greatly from a color actually displayed.

It is, therefore, the object of this invention to provide a color image display system capable of simultaneously displaying a plurality of images using a single color lookup table in which original colors are precisely displayed.

The means for solving the stated problems and object are in accordance with the present invention basically the following: a color lookup table (hereinafter referred to as CLT) is divided into a shared area which is shared by a plurality of color images, and a plurality of dedicated areas corresponding to the respective color images; in the shared area, colors which can be used by each image in common are stored while in each dedicated area, colors proper to the corresponding image are stored.

In an embodiment of this invention, the colors stored in the shared area are selected by the uniform sampling of a given color space (e.g. RGB space), and the colors stored in each dedicated area are selected by the adaptive sampling of a corresponding image. In case of the adaptive sampling, frequently used colors are selected, and additional colors are also selected based on brightness from a chromaticity group including a larger number of pixels than a predetermined value.

The advantages gained with the present invention are the following. Since each image uses both the shared and dedicated colors, it is possible to display with more accurate colors than in the prior art systems which use only one of the shared and dedicated colors. When an image is changed, it is sufficient to rewrite only colors in a corresponding dedicated area and there is no need to rewrite the entire CLT.

In the following description the invention is described in more details in connection with prefered enbodiments shown in the drawing, in which

Fig. l is a block diagram illustrating the configuration of a color image display system to which this invention can be applied;

Fig. 2 is a diagram illustrating the configuration of a CLT and the relationship between the CLT and images;

Fig. 3 is a block diagram illustrating the configuration of a quantizer;

Fig. 4 is a flowchart showing a quantization algorithm;

Fig. 5 is a diagram illustrating the calculation of chromaticity;

Fig. 6 is a disgram illustrating a chromaticity histogram;

Fig. 7 is a diagram illustrating the extraction of colors around a peak, and

Fig. 8 is a flowchart showing a representative color calculation algorithm.

Although this invention may be implemented in any color space, it will be described using the RGB space as an example, which is easiest to understand.

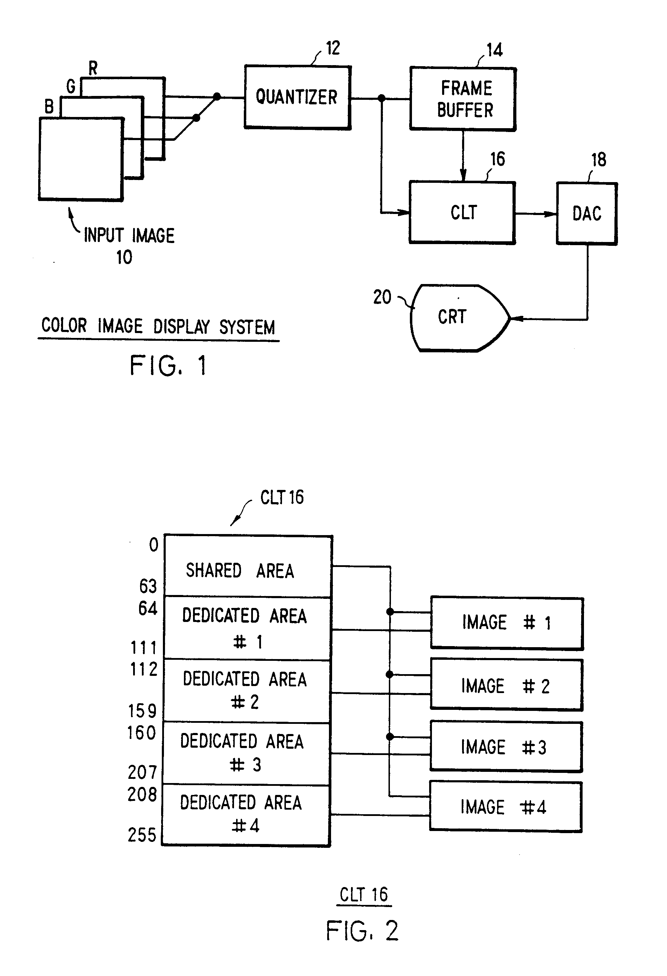

Fig. 1 shows a color image display system according to this invention. An input image 10 to be displayed on a color cathode ray tube CRT 20 is supplied from an image file or a scanner (both not shown), and each pixel thereof consists of n (e.g. 8) bits for each of R (Red), G (Green) and B (Blue). The pixel data of 3n bits are sent to a quantizer 12 to select representative colors and to write in a frame buffer. The quantizer 12 processes all the pixel data of the input image 10 twice. First, they are processed to select the representative colors to be written in a CLT (color lookup table) 16, and second, to calculate and write in the frame buffer 14, for each pixel, an encoded data for accessing the CLT 16. Details of the configuration and operation of the quantizer 12 will be described later.

As is well known in the art, locations in the frame buffer 14 correspond to dot positions on a CRT screen, respectively. In this embodiment, it is assumed that a pixel data to be written in each location of the frame buffer 14 consists of eight bits. Therefore, the capacity of the CLT 16 accessed by such a pixel data is 256 words. In other words, 256 representative colors can be stored in the CLT 16. Each color is assumed to be expressed by twelve bits (four bits for each of R, G and B). The maximum number of display colors is 4096. It is noted that these values are only for the purpose of description of the embodiments, and this invention is not limited to these values.

A representative color read from the CLT 16 using an eight bit pixel data in the frame buffer 14 is converted by a digital to analog converter (DAC) 18 into analog signals used to drive the CRT 20. Thus, a desired color image is displayed on the screen of the CRT 20.

Fig. 2 shows the configuration of the CLT 16 and the relationship between the CLT 16 and each image. Unlike the conventional CLT's, the CLT 16 of this invention is logically divided into a shared area and a plurality of dedicated areas corresponding to the respective images. The shared area is used in common by a plurality of images displayed on the CRT 20. Each of the dedicated areas is used only by a corresponding image. In this embodiment, the shared area contains 64 predetermined colors, and each dedicated area contains 48 colors which may be changed by the quantizer 12. Therefore, each image can use up to 112 (64 + 48) colors. If the capacity of the CLT 16 is 256 words, the number of the dedicated areas is four. In that case, the CRT 20 displays four color images. In Fig. 2, it should be noted that lines between each area of the CLT 16 and images merely show the relationship therebetween and do not physically exist.

Next, a method for selecting the representative colors to be stored in the shared and dedicated areas will be described. Sixty-four colors to be stored in the shared area are determined by the uniform sampling of the RGB space. Since each representative color has four bits for each of the R, G and B component, the decimal value of each component varies between 0 and 15 inclusive. The sixty-four representative colors may be determined by choosing, for example, 0, 5, 10 and 15 from the possible decimal values. In that case, if each representative color is expressed by (R, G, B), they are (0, 0, 0), (0, 0, 5), (0, 0, 10), (0, 0, 15), (0, 5, 0), (0, 5, 5), ..., (15, 15, 15).

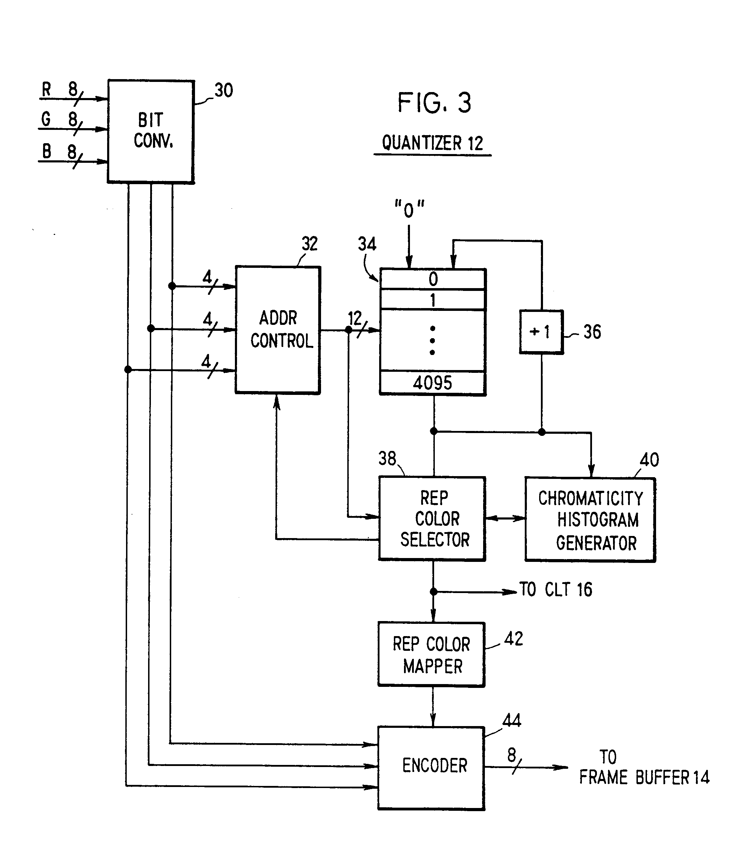

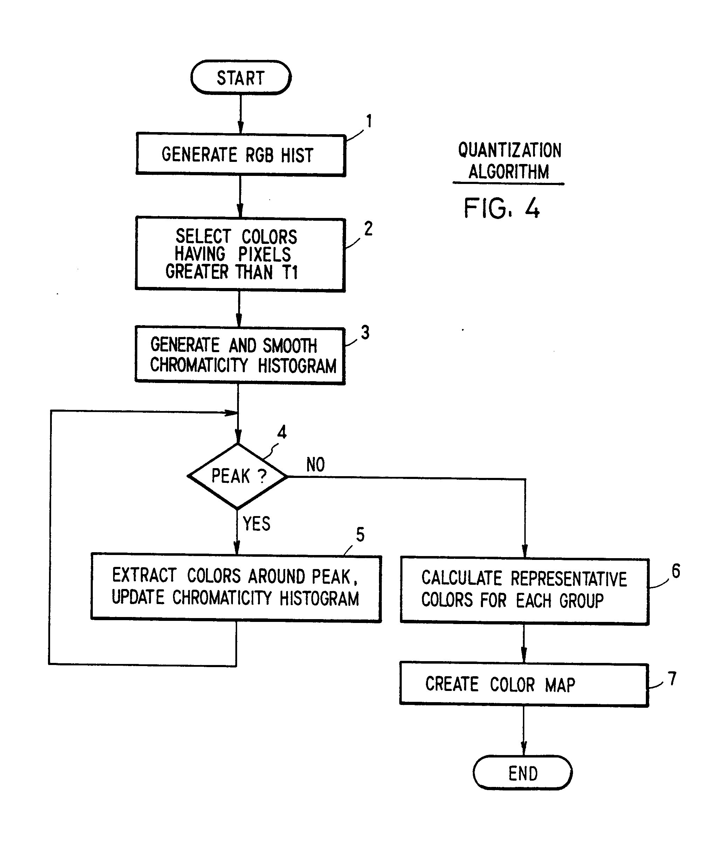

The representative colors to be stored in the dedicated areas are selected by the quantizer 12 for each image. Fig. 3 shows the configuration of the quantizer 12, and Fig. 4 shows a flow of the quantization algorithm.

As shown in Fig. 3, the pixel data with eight bits for each of R, G and B is converted to a pixel data with four bits for each of R, G and B by a bit converter 30. The bit converter 30 outputs the higher four bits of the R, G and B components. An address control 32 uses the converted pixel data as a twelve bit address to access a count register array 34. The array 34 contains 4096 count registers, and the content of an addressed count register is incremented by one in an incrementing device 36 and written back in the same location. By repeating the above process for every pixel in the input image, the number of pixels of each color in the input images is determined.

The contents of the array 34 are read out to a representative color selector 38 and a chromaticity histogram generator 40 under the control of the address control 32. The representative color selector 38 selects up to 48 representative colors based on color distribution in the input image, and stores them in a dedicated area of the CLT 16 which corresponds to the input image involved. A representative color mapper 42 maps the colors in the RGB space (4096 colors in this embodiment) to the representative colors stored in the CLT 16. An encoder 44 encodes the pixel data with four bits for each of R, G and B components into an eight bit CLT address based on the map information from the representative color mapper 42, and writes it in the frame buffer 14.

Next, referring also to Fig. 4, the operation of the quantizer 12 will be described stepwise. The quantization involved belongs to the adaptive sampling, and is performed for each image.

Step 1

An RGB histogram (a graph showing the relationship between colors and numbers of pixels) is generated in a space with four bits for each of the R, G and B components from the input image. This is performed by the count register array 34 and the incrementing device 36 as described before. During step 1, the representa-tive color selector 38, the chromaticity histogram generator 40, the representative color mapper 42 and the encoder 44 are all inactive.

Step 2

Colors having a great number of pixels, such as a background color, are selected as representative colors and then deleted from the histogram. This is to prevent a peak of chromaticities, which is to be detected in succeeding steps, from being biased to the chromaticity of the background color. Therefore, in Fig. 3, the representative color selector 38 is activated to receive the content of each count register sequentially read out under the control of the address control 32, and the associated twelve bit address. The representative color selector 38 compares the content of the count register, i.e. the number of pixels, with the following threshold TI, and if the former is greater, it saves the twelve bit address received simultaneously as a representative color, and further informs the address control 32 of this saving. The address control 32 responds to it and resets the count register presently addressed to zero.

$$T1 = (Pt/Ra) k1$$

In the above equation, Pt is the total number of pixels in the histogram, Ra is the number of remaining representative colors, and k1 is a constant. The initial value of Pt is determined by the resolution of the input image which is, for example, 262144 (512 x 512). The initial value of Ra is 48 in this embodiment. Since (Pt/Ra) represents the average number of pixels per representative color, the above equation indicates that each color having a greater number of pixels than k1 times of the average value is selected as a representative color. The constant k1 is fixed to a certain value, e.g. five. Pt and Ra may be either constants or variables. When they are handled as variables, each time the representative color selector 38 selects a representative color, it subtracts the number of pixels of the selected color from Pt and subtracts one from Ra. The above equation has been adopted considering a wide region of uniform chromaticity and brightness such as the background. However, any color already selected for the shared area is neglected even if it contains a greater number of pixels than T1.

Step 3

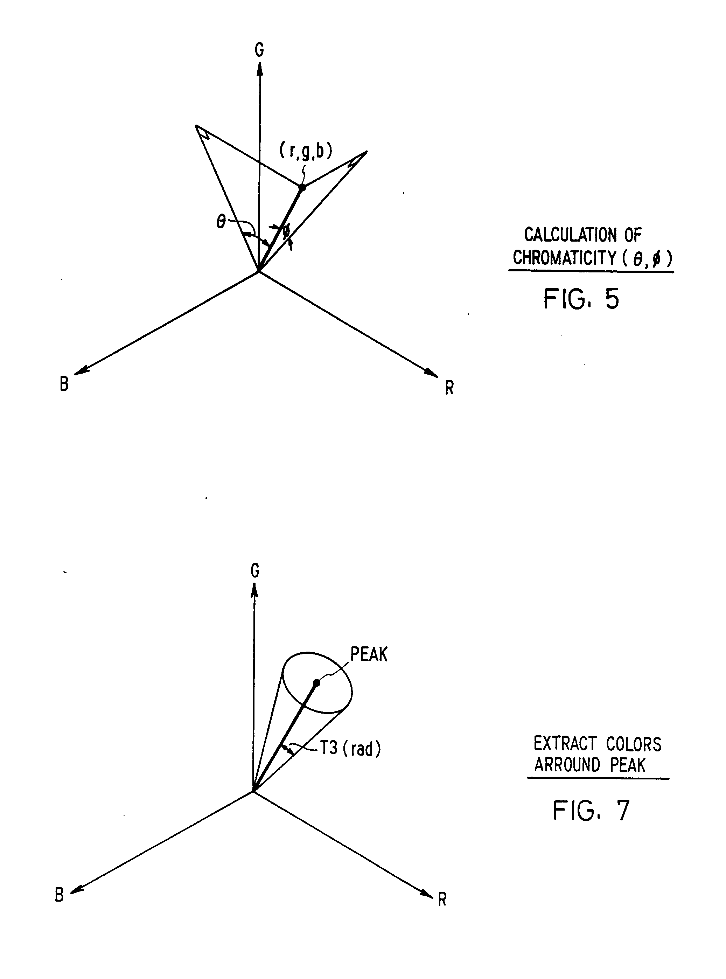

A chromaticity histogram is generated. Here, an RGB ratio is defined as a chromaticity. Referring to Fig. 5, the chromaticity is represented by angles $\theta$ and $\phi$ which are made in the RGB space by a line connecting the origin to the color (r, g, b) involved and the GB and GR planes, respectively. $\theta$ and $\phi$ are calculated by the following equations:

$$\theta = \arcsin \{r/(r^2 + g^2 + b^2)^{1/2}\}$$
$$\phi = \arcsin \{r/(r^2 + g^2 + b^2)^{1/2}\}$$

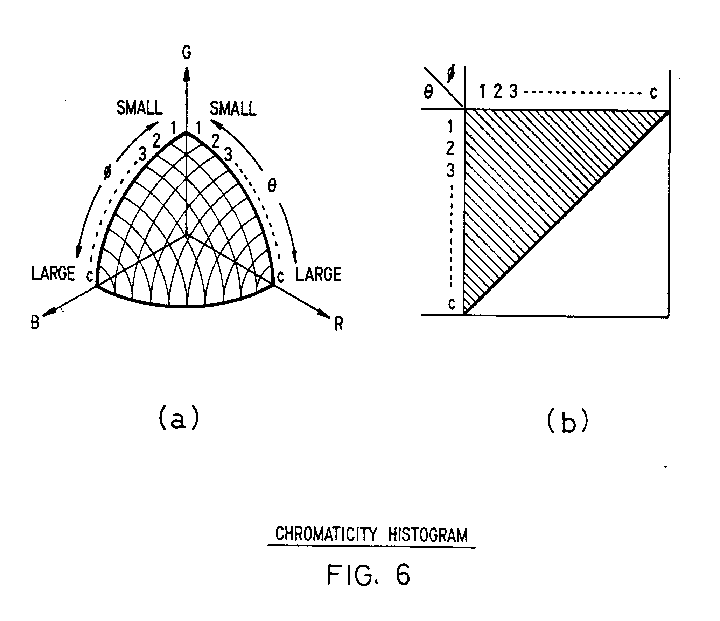

Although each of $\theta$ and $\phi$ may take a value between 0° and 90° inclusive, $\theta + \phi$ never exceeds 90° as can be seen from Fig. 5. When the chromaticity histogram is generated, the ranges of $\theta$ and $\phi$ are equally divided into c subranges (e.g. 25 subranges), and the number of pixels falling within each subrange is determined. Fig. 6 (a) shows the division in the RGB space, and Fig. 6 (b) shows it in a matrix form. Once the maximum number of colors displayed (4096 in this embodiment) is determined, $\theta$ and $\phi$ of each of the colors are uniquely identified so that each count register in the array 34 shown in Fig. 3 can previously be made to correspond to each subrange of $\theta$ and $\phi$, that is, each matrix element in the hatched area of Fig. 6 (a). Therefore, when the chromaticity histogram is generated, the chromaticity histogram generator 40 is activated to receive count values sequentially read out of the array 34 under the control of the address control 32. The chromaticity histogram generator 40 generates the chromaticity histogram by accumulating for each matrix element the contents of corresponding count registers.

Next, the following mask is used on the histogram of the matrix form to smooth the numbers of pixels.

$$
\begin{array}{ccc}
\mathbf{M} & \mathbf{M} & \mathbf{M} \\
\mathbf{M} & \mathbf{1} & \mathbf{M} \\
\mathbf{M} & \mathbf{M} & \mathbf{M}
\end{array}
$$

M is a mask value between 0 and 1 inclusive. Here, M is assumed to be 0.5. When the above mask is used, its center is aligned with a value to be smoothed and the value is updated by adding thereto M times of each of its upper, lower, left, right, upper right, lower right, upper left and lower left values. This smoothed histogram is generated separately from the original chromaticity histogram, which remains as it is.

Step 4

After the histogram consisting of the smoothed matrix elements has been generated, the representative color selector 38 selects as a peak a matrix element containing the maximum value among the smoothed values greater than the following threshold T2.

$$T2 = (Pt/Ra) k2$$

The representative colors selected in step 2 have been removed from Pt and Ra. k2 is a constant, preferably equal to k1 in the previous equation. If k2 is made greater, the number of peaks selected decreases and, correspondingly, a larger number of colors are selected per peak.

Step 5

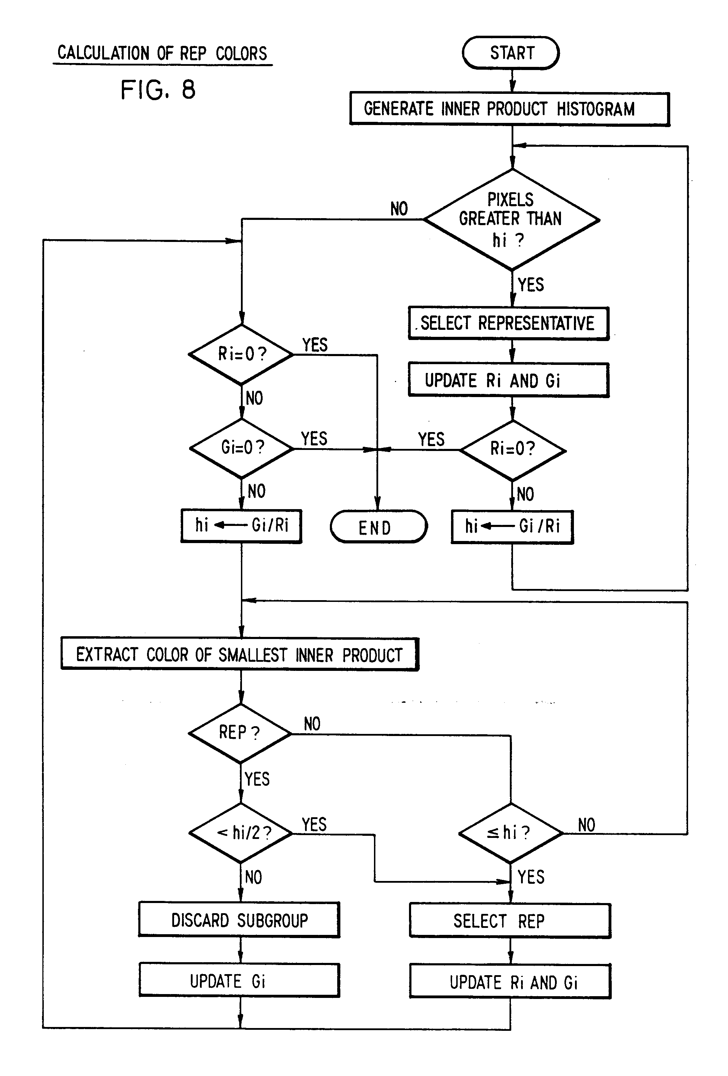

In the RGB space, colors within the range of the following threshold T3 (radian) arround the peak detected in step 4 are extracted. This is shown in Fig. 7.

$$T3 = (0.5 = M) \pi/2c$$

The peak position shown in Fig. 7 is assumed to be the center of a corresponding mesh in Fig. 6 (a). In the above equation, $\pi/2c$ approximates to the length of a side of a mesh. M is the above mask value. If M = 0.5 and c = 25, then T3 $= \pi/50$. If the values of M and c are fixed, the colors within the range of T3 can previously be obtained for each mesh of Fig. 6 (a). The representative color selector 38 is provided with a table of 325 meshes (matrix elements) and correspon-ding colors within the range of T3. When the selector 38 detects a peak, it fetches corresponding colors from the table and saves them as a group. The representative color selector 38 then transfers an identifier of the element detected as a peak to the chromaticity histogram generator 40 to update the chromaticity histogram. The chromaticity histogram generator 40 resets the identified element to zero in the original chromaticity histogram which has not been smoothed, and after subtracting the number of pixels of the colors which were within the range of T3 of the peak from surrounding elements, it performs smoothing again using the chromaticity histogram thus updated.

In this time, only a portion related to the updated elements in the original chromaticity histogram is re-calculated. After this, the procedure returns to step 4, and steps 4 and 5 are repeated until a peak greater than T2 is no longer detected.

Step 6

The representative color selector 38 calculates the number of representative colors which is to be assigned to each group selected in step 5 using the following equation:

$$Ri = (Gi/\sum_{j=1}^{m} Gj)\ Ra$$

In the above equation, Ri is the number of representative colors which is to be assigned to the i-th group, Gi is the number of pixels of the i-th group, Ra is the number of remaining representative colors, and m is the number of groups selected in step 5. The above equation shows that the number of representative colors which is to be assigned to each group is proportional to the number of pixels in the group involved. Although each number of pixels can be obtained from the count register array 34, the colors in the shared area are not included in the calculation.

When Ri has been obtained, the representative color selector 38 generates a histogram using an inner product of a vector, in the RGB space, of each color contained in the group involved and a unit vector in the peak direction. This histogram is generated by arranging the numbers of pixels sequentially in order of the inner product values. The table of meshes and extracted colors described above contains the inner product value for each extracted color, and the re-presentative color selector 38 accesses this table to generate the histogram. Since the inner product here is obtained by projecting the vector of each color on the peak line, it corresponds to the brightness of each color.

The representative color selector 38 then selects a color (not in the shared area) having the greater number of pixels than hi ( = Gi/Ri) in the inner product histogram as a representative color. hi is the average number of pixels per representative color in the group. After selecting a color, the representa-tive color selector subtracts one from Ri and the number of pixels thereof from Gi to update hi. In this way, the selection of representative colors and updating of hi are repeated until a color having the greater number of pixels than the updated hi is no longer detected. However, if Ri is found to be zero before updating hi, the selection of representative colors is stopped.

If the number of representative colors selected in the above process is smaller than the initially calculated value of Ri, the representative color selector 38 selects one or more additional representative colors in the following manner.

In principle, a representative color is determined in each subgroup which is formed by grouping every hi pixels sequentially starting from the smallest inner product in the inner product histogram, i.e. the darkest color. If any representative color which has already been selected is encountered during the grouping, it is stopped immediately, and if the number of pixels in a current subgroup is equal to or smaller than hi/2, this subgroup is discarded. On the other hand, if the number of pixels is greater than hi/2, the subgroup involved is treated as an independent subgroup from which a representative color is selected. In this case the value of hi is also sequentially updated. When a representative color is selected in each subgroup, the average of group members is used. Fig. 8 shows the flow of step 6.

The representative color selector 38 writes the selected representative colors into a dedicated area in the CLT 16 corresponding to the input image involved, and informs the representative color mapper 42 of the representative colors and CLT addresses.

Step 7

A table of the respective colors in the RGB space and corresponding representative colors stored in the CLT 16 (referred to as representative color map) is prepared. For this purpose, the representaive color mapper 42 calculates distances between each color in the RGB space and the selected representative colors. At that time, since the colors for the shared area have been selected by the uniform sampling, a represen-tative color always exists for any color within the following distance d therefrom.

$$d = \{3(m/2s)^2\}^{1/2}$$

The above equation assumes the case where s $\times$ s $\times$ s colors are distributed with a uniform interval in an m $\times$ m $\times$ m space. In this embodiment, since m = 16 and s = 4, d is approximately 3.5. Therefore, for each of the representative colors, only distances from colors within d are calculated and a representative color with the smallest distance is assigned to the relevant color. In this way, the representative color mapper 42 creates the representative color map containing as an entry the address of the CLT 16 for each of 4096 colors in the RGB space. Thereafter, the system scans the input image again and transmits the output of the bit converter 30 to the encoder 44 where the pixel data with four bits for each of R, G and B components is converted into the address of the CLT 16 by using the representative color map, and written in a corresponding location in the frame buffer 14. By repeating the above steps for each input image, a plurality of images can be displayed simultaneously with appropriate colors on the CRT 20.

**Claims**

1. A color image display system for displaying color images by writing quantized input images in a frame buffer and accessing a color lookup table by the contents of said frame buffer, characterized in that said table is divided into a shared area and a plurality of dedicated areas corresponding to the respective images, said shared area stores colors used by a plurality of color images in common, and each of said dedicated areas stores colors proper to a corresponding color image.

2. A color image display system as claimed in Claim 1, further characterized in that the colors stored in said shared area are selected by the uniform sampling of a given color space, and the colors stored in each of said dedicated areas are selected by the adaptive sampling of a corresponding image.

3. A color image display system as claimed in Claim 2 further characterized in that in said adaptive sampling, colors are selected, on the basis of brightness, from a chromaticity group having a larger number of pixels than a predetermined value, in addition to the colors frequently used.

**Revendications**

1. Système d'affichage d'image en couleur pour afficher des images en couleur en écrivant des images d'entrée quantifiées dans une mémoire tampon d'image et en accédant à une table de consultation de couleurs par les contenus de ladite mémoire-tampon d'image, caractérisé en ce que ladite table est divisée en une zone partagée et en une pluralité de zones spécialisées correspondant aux images respectives, ladite zone partagée mémorisant les couleurs utilisées par une pluralité d'images en couleur en commun, et chacune desdites zones spécialisées mémorisant les couleurs propres à une image en couleur correspondante.

2. Système d'affichage d'image en couleur selon la revendication 1, caractérisé de plus en ce que les couleurs mémorisées dans ladite zone partagée sont choisies par l'échantillonnage uniforme d'un espace de couleur donné et en ce que les couleurs mémorisées dans chacune desdites zones spécialisées sont choisies par l'échantillonnage adaptatif d'une image correspondante.

3. Système d'affichage d'image en couleur selon la revendication 2, caractérisé de plus en ce que, dans ledit échantillonnage adaptatif, les couleurs sont choisies, sur la base de la brillance, dans un groupe de chromaticités ayant un nombre de pixels plus grand qu'une valeur prédéterminée en plus des couleurs fréquemment utilisées.

**Patentansprüche**

1. Farbbild-Anzeigesystem für die Anzeige von Farbbildern durch Einschreiben quantifizierter Eingangsbilder in einen Rahmenpuffer und Zugreifen auf eine Farbsuchtabelle durch die Inhalte besagten Rahmenpuffers, dadurch gekennzeichnet, daß besagte Tabelle in einen gemeinsam genutzten Bereich und eine Mehrzahl von dedizierten Bereichen, die den zugeordneten Bildern entsprechen, aufgeteilt ist, wobei besagter gemeinsamer Bereich Farben speichert, die durch eine Mehrzahl von Farbbilder gemeinsam genutzt werden, und jede der besagten dedizierten Bereiche Farben speichert, die einem entsprechenden Farbbild eigen sind.

2. Farbbild-Anzeigesystem nach Anspruch 1, weiterhin dadurch gekennzeichnet, daß die in besagtem gemeinsamen Bereich gespeicherten Farben durch einheitliches Abtasten eines vorgegebenen Farbraums ausgewählt werden, und die Farben, die in jedem der dedizierten Bereiche gespeichert sind, durch adaptives Abtasten des entsprechenden Bildes ausgewählt werden.

3. Farbbild-Anzeigesystem nach Anspruch 2, weiterhin dadurch gekennzeichnet, daß in besagtem adaptiven Abtasten Farben ausgewählt werden auf der Basis der Leuchtkraft, von aus einer chromatischen Gruppe, die eine größere Anzahl von Bildpunkten aufweist als einem vorgegebenen Wert entspricht, zusätzlich zu den häufig benutzten Farben.

COLOR IMAGE DISPLAY SYSTEM

FIG. 1

CLT 16

FIG. 2

# FIG. 3

## QUANTIZER 12

QUANTIZATION
ALGORITHM

FIG. 4

```
            ( START )
                |
                v
        ┌───────────────────┐ 1
        │ GENERATE RGB HIST │
        └───────────────────┘
                |
                v
        ┌───────────────────┐ 2
        │   SELECT COLORS   │
        │   HAVING PIXELS   │
        │  GREATER THAN T1  │
        └───────────────────┘
                |
                v
        ┌───────────────────┐ 3
        │ GENERATE AND SMOOTH│
        │ CHROMATICITY HISTOGRAM│
        └───────────────────┘
                |
                v
             4
           /◇\          NO
          < PEAK ? >──────────────┐
           \◇/                    │
            |                     │
           YES                    │
            |                     v
┌───────────────────────┐ 5   ┌───────────────────────┐ 6
│ EXTRACT COLORS AROUND │     │ CALCULATE REPRESENTATIVE│
│ PEAK, UPDATE          │     │ COLORS FOR EACH GROUP  │
│ CHROMATICITY HISTOGRAM│     └───────────────────────┘
└───────────────────────┘                │
            │                             v
            │                  ┌───────────────────────┐ 7
            └──(loop back)      │   CREATE COLOR MAP    │
                               └───────────────────────┘
                                          │
                                          v
                                      ( END )
```

CALCULATION OF
CHROMATICITY ( θ,∅ )

FIG. 5

EXTRACT COLORS
ARROUND PEAK

FIG. 7

(a)

(b)

CHROMATICITY HISTOGRAM

FIG. 6

EP 0 210 423 B1

CALCULATION OF REP COLORS

FIG. 8

13